# EUROPEAN PATENT APPLICATION

(11) **EP 2 080 947 A1**
(43) Date of publication of application: **22.07.2009**
(21) Application number: 07738652.2
(22) Date of filing: 15.03.2007
(51) Int. Cl.: F21S 2/00, H01L 33/00

(54) **FLEXIBLE LUMINESCENT MATERIAL**

(30) Priority: 20.10.2006 JP 2006285720
(71) Applicant: Contents Co., Ltd., Tokyo 153-0064 (JP)
(72) Inventor: Jin Hwan Kim, Namdong-Gu Incheon 405-846 (KR)
(74) Representative: Müller-Boré & Partner Patentanwälte
(86) International application number: PCT/JP2007/055202
(87) International publication number: WO 2008/047484

(57) **Abstract**

An object of the invention is to provide a flexible light-emitting device that can be flexible, consume minimal electrical power, have a prolonged operation life, and be small-sized. There is provided a light-emitting device molded into the form of a sheet using a flexible resin and having light-emitting elements disposed on a flexible substrate that is a flexible sheet-like wired substrate, the flexible light-emitting device **characterized in that** the light-emitting elements are disposed in a row at predetermined intervals on one end part of one surface side of the flexible substrate.

## Description

### TECHNICAL FIELD

The present invention relates to technology for an illumination or display device in which light-emitting diodes are employed, and more particularly to a device having minimal electrical power consumption, a prolonged operation life, and the capability to be used in any location regardless of the space in which the illumination is disposed.

### BACKGROUND ART

Light-emitting diodes have conventionally been used in place of light bulbs and the like as illumination light sources.
Due to the fact that light-emitting diodes consume a small amount of electrical power and have a long operation life, they are used as a variety of illumination light sources or as display light sources for traffic signals and the like.
Over the past several years, as blue LEDs have been developed and brought into widespread use, light-emitting diodes have come to be used as display light sources for a variety of illumination, signage, and other applications using the three primary colors of red, blue, and green.

There have also been proposed illumination and display light sources in which the light-emitting diodes are arranged in a plurality of rows and coated with a plastic material.
In one example of such an application, light-emitting chips are installed on a flexible printed wiring board, and the light-emitting chips and the flexible printed wiring board are sealed using a flexible, translucent plastic material (as in, e.g., Patent Document 1).
There have also been proposed applications wherein notches are formed between one LED chip installation point and another LED chip installation point set in an arranging part on which several LED chips are arranged, the notches allowing the arranging part to be bent avoiding the installation points (for example, see Prior Art Document 2).

[Patent Document 1]: Japanese Laid-open Patent Publication No. 9-50253
[Patent Document 2]: Japanese Laid-open Patent Publication No. 2004-103993

### DISCLOSURE OF THE INVENTION

### [Problems the Invention Is Intended to Solve]

However, problems have been associated with the abovementioned conventional light-emitting devices because the fact that the light-emitting diodes are attached to a center of one surface of a substrate means that the width of the substrate dictates the size of the placement area, the light-emitting device cannot be efficiently disposed in locations having only little space, and the applications and locations in which the light-emitting device can be used are limited.
Problems have also been presented in that, conventionally, transmittance has been poor and brightness is reduced because the molded resin is semi-transparent.
Moreover, in cases where light-emitting elements are disposed in the central part of a substrate and light is emitted from one surface thereof, as in the prior art, the thickness of the resin on the light-emitting elements has been dependent upon the thickness of the molding resin. Therefore, even when the resin is made thinner than necessary and an attempt is made to increase the translucency, limitations have been imposed by the mold strength and other such factors.

In the past, when attempts have been made to adjust the length of the light-emitting device according to the location in which the light-emitting device will be disposed or other parameters, it has been necessary to produce in advance a light-emitting device having a length to match the available space. As a result, in a case where the light-emitting device is to be attached on-site or elsewhere, it has not been possible in such locations to adjust the length of the light-emitting device to a desired length.

The present invention is intended to solve the aforementioned problems, and has as an object to provide a flexible light-emitting device that can be flexible, consume minimal electrical power, have a prolonged operation life, and be small-sized.

### [Means for Solving the Problems]

In order to achieve the abovementioned object, a flexible light-emitting device according to one aspect of the present invention is a light-emitting device wherein light-emitting elements are disposed at predetermined intervals on a flexible wired substrate, and the flexible substrate is covered by a soft resin; and is **characterized in that** the light-emitting elements are structured into units, each comprising several light-emitting devices as a single set, and are structured to be capable of being cut between each of the units to achieve a desired length.
A flexible light-emitting device according to another aspect is a light-emitting device molded into the form of a sheet using a flexible resin and having light-emitting elements disposed on a flexible wired substrate; and is **characterized in that** the light-emitting elements are disposed in a row at predetermined intervals on one end part of the flexible substrate, and are disposed so as to be imparted with directivity in the thickness direction of the molding resin that is formed in the shape of a sheet.

Light is thereby emitted by the light-emitting device from an end part, and accordingly the substrate is disposed upright when the light-emitting device is arranged; therefore, irrespective of the area of the substrate, the profile can be made smaller in size, and the light-emitting device can be used efficiently in smaller places as well, regardless of the amount of space or other factors.

The abovementioned flexible substrate may also be covered by configuring the abovementioned flexible resin into the shape of a hollow tube, and inserting and sealing the abovementioned flexible substrate within the abovementioned tube-shaped flexible resin.
The plastic may be a transparent urethane resin. Urethane resins do not give off volatile substances but have particularly exceptional adhesive strength and water-resistance; therefore, using such resins thus makes it possible for molding to be performed in a state allowing the properties and performance of the substrate to be maintained, and for brightness to be increased. The resin is not limited to urethane resins; resins based on silicone or the like may also be used.

The light-emitting devices may be structured into units, each comprising several light-emitting devices as a single set; an electrode clasp may be disposed between each of the units; and the electrode clasps may be structured so as to be capable of being cut.
A hole for attaching a wiring cord used to establish a connection to an exterior electrode may be formed in the abovementioned electrode clasp. It is thus possible to obtain a light-emitting device of a desired length. Moreover, the clasps at the cutting sites can be used for establishing a connection with an exterior electrode, and operational efficiency can be increased.
The abovementioned light-emitting elements may furthermore be "side-view" type light-emitting elements.

### [Effects of the Invention]

According to the present invention it is possible to provide an illumination or display device having minimal consumption of electrical power, a prolonged operating life, and small size.
Application in all types of illumination is accordingly facilitated; and structural, spatial, and visual effects can be realized to the maximal extent.

### BEST MODE FOR CARRYING OUT THE INVENTION

The present invention is described hereunder with reference to an example in which the present invention is applied to a light-emitting device.

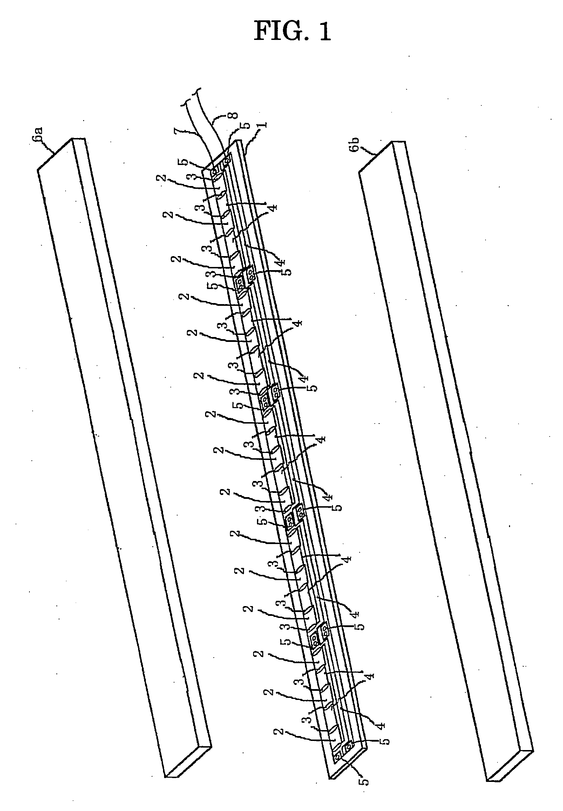

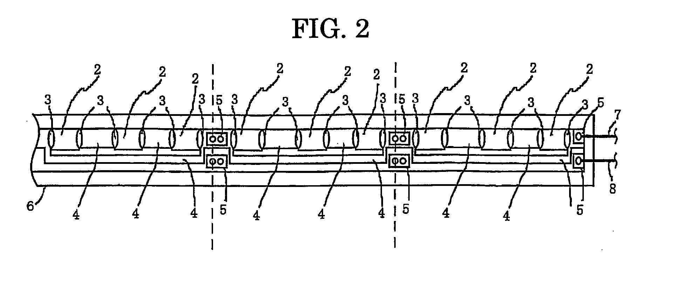

FIG. 1 is a perspective view of a flexible light-emitting device according to the present embodiment. The light-emitting device of FIGS. 1 and 2 comprises a substrate 1, light-emitting devices 2 attached to the top of the substrate 1, and a soft resin part 6 for molding the substrate 1 and the light-emitting devices 2.

The substrate 1 is a flexible substrate constructed using flexible printed circuits (FPCs), and is formed into the shape of a thin sheet.
The light-emitting elements 2 are disposed at substantially equidistant intervals on the substrate 1 in a row along an upper end part of the lateral surface of the substrate 1 shown in the drawing. As shown in FIG. 2, the light-emitting elements 2 are thus disposed in a row on the lateral surface (on one end part) of the substrate 1. In the present example, the light-emitting elements 2 are "side-view"-type elements constructed from gallium nitride (GaN), and are white LEDs imparted with directivity in the thickness direction of the molding resin (vertically in the drawing), as a result of being subjected to an electrical charge.
The color of the light emissions is not limited to white. For example, a blue light-emitting diode may also be used.

The light-emitting elements 2 are structured as units containing three elements as a single set, and electrode clasps 5 are vertically arranged and attached in pairs on a boundary of each of the units. Electrode clasps 5 on each of an upper side and a lower side as viewed in the drawing are electrically connected to a positive electrode side and a negative electrode side, respectively.
The electrode clasps 5 are constructed as thin sheets of copper or another electrical conductor. Two through-holes are formed in the electrode clasps 5 to the left and right in the drawing, and are configured to be capable of being wired to an exterior power source. Using pincers, scissors, or another cutting tool to cut the electrode clasp 5 along the dashed lines in the drawing makes it possible to obtain a light-emitting device of a desired length. For example, cutting what is originally a 2-m-long light-emitting device 1 partway therealong makes it possible to obtain a length of 1 m and 50 cm, 80 cm, or another desired length.

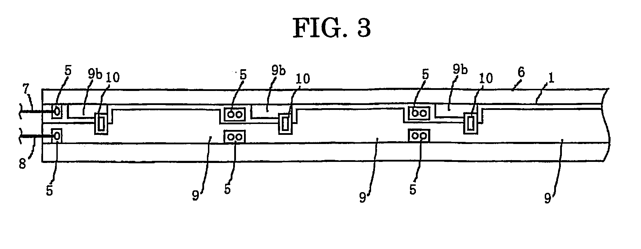

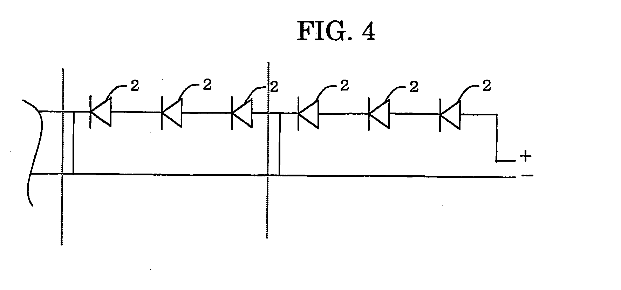

Leads 4, 9 for electrically connecting the light-emitting elements 2 are provided to either side of the substrate 1. The leads 4, 9 can be formed using copper thin-film printing.
The printed lead 4 is wired as one pole (e.g., the positive pole) so as to serially connect the light-emitting elements 2 on the lateral face as shown in FIG. 2, and the lead 9 on the reverse side shown in FIG. 3 is wired as the other pole (e.g., the negative pole).
Solder 3 is used to establish an electrical connection between the light-emitting elements 2 and the lead 4. Since it is assumed in the present example that the light-emitting elements 2 are in units containing three elements as a single set, the lead 4 is formed so as to connect the light-emitting elements 2 at either end part in a given unit.
As shown in FIG. 4, the light-emitting elements 2 are thus in a state of being connected in series.
On the reverse surface, resistors 10 are connected between the light-emitting elements 2, as shown in FIG. 3.

The electrode clasps 5 are connected to end parts of the lead 4; and wiring cords 7, 8 extending from the electrode clasp of an end part of the substrate 1 toward the exterior power source are connected to an end part of the lead 4.
This arrangement enables electricity to be provided from an exterior direct-current power source.

The resin part 6 to be molded on the substrate 1 is fashioned into the form of a sheet covering the lateral surface and reverse surface of the substrate 1.
The resin part 6 is formed from a transparent, soft urethane resin. As a result, the resin part 6 is glossy, as well as being exceptionally flexible, chemically resistant, and waterproof. The resin part 6 completely covers the substrate 1, and is therefore wider than the substrate 1, as shown in FIGS. 2 and 3.

In a case where a light-emitting device of the abovementioned structure is used, passing a current (in the present example DC 12V, 20 mA) through the wiring cords 7, 8 in a state wherein a connection has been established with the exterior direct current power source allows the current to pass to the light-emitting elements 2 via the leads 4, 9, causing the light-emitting elements 2 to emit light, the emitted light to shine through the upper end part and other regions of the resin part 6, and the function of a display unit to be achieved. The light-emitting device will have directivity in the thickness direction of the sheet-form substrate 1 and the resin 6 (vertical direction in the drawing), and in the present example, light diffuses from the light-emitting elements 2 at an angle of 120°. The thickness of the resin on the light-emitting devices 2 is as thick as the resin of the lateral surface, and is not dependent upon the thickness of the resin on the substrate 1.

A method for manufacturing the abovedescribed light-emitting device is described hereunder.
First, leads 4, 9 are printed onto a substrate 1 to which power source clasps 5 are attached at predetermined intervals.
Light-emitting elements 2 are then attached at predetermined intervals, and the light-emitting elements 2 are soldered to the lead 4. Wiring cords 7, 8 are attached to an electrode clasp 5 on an end part of the substrate 1. Passing electricity through the wiring cords 7, 8 in this state makes it possible to check the connection state in terms of whether or not the light-emitting elements 2 emit light.

A molding resin is subsequently injected into a silicone die to which a release agent has been previously applied, and deaerated. The resin is cured at 70 to 80°C and removed.
The light-emitting device in which the light-emitting elements 2 have been confirmed to have illuminated is then washed in an ultrasound bath, and subsequently allowed to dry unassisted in order to allow any matter adhering to the surface to evaporate.

Disconnected restraints are inserted in 2 or 3 locations at a pitch of 10 mm, and the coating height is adjusted to a uniform level.
After the molding has concluded, the horizontal orientation is maintained, the deaerated resin is injected and deaerated one more time (deaerated for one minute after being kept at 760 mHg), silicone burrs are removed while the molding surface is kept horizontal, the surface is provided with a finish by being heated with a burner, and the assembly is dried and allowed to cure to complete the process.

According to the abovedescribed embodiment, since the substrate 1 is molded using a resin 6, it is possible for electrical power consumption to be minimized, operation life to be prolonged, and size to be reduced. Moreover, the light-emitting elements 2 are disposed in a row on one end part on the substrate 1 at predetermined intervals, and the light-emitting elements 2 are disposed so as to impart the resin 6 with directivity in the thickness direction. Therefore, the light-emitting surface when the light-emitting device is attached can be made narrower than in a case where the light-emitting elements 2 are disposed in the widthwise center of a top surface of a conventional substrate 1, and it is possible to provide a small-size illumination or display device employing light-emitting diodes.
The light-emitting elements 2 are disposed in a row on a temporary part (in the width direction) of the substrate 1 and the resin 6, and directivity is imparted in the width direction. The interval over which the light-emitting devices are disposed can accordingly be shortened. Therefore, the present invention can be readily used in all types of illumination; the degree of latitude with respect to structural, spatial, and visual effects can be increased, and these effects can be realized to the maximal extent.

The light-emitting elements 2 are structured as units containing several elements as a single set, and the electrode clasps 5 are disposed between each of the units. The electrode clasps 5 are designed to be cut; therefore, when the light-emitting device is to be placed in an actual application, cutting the light-emitting device at the electrode clasp 5 makes it possible to readily obtain a light-emitting device of a desired length.
There are formed in the electrode clasps 5 through-holes through which wiring cords for establishing a connection to an exterior electrode are attached; therefore, the clasps 5 are readily cut, and, in a case where the cut portion is to be wired, wiring is readily performed.

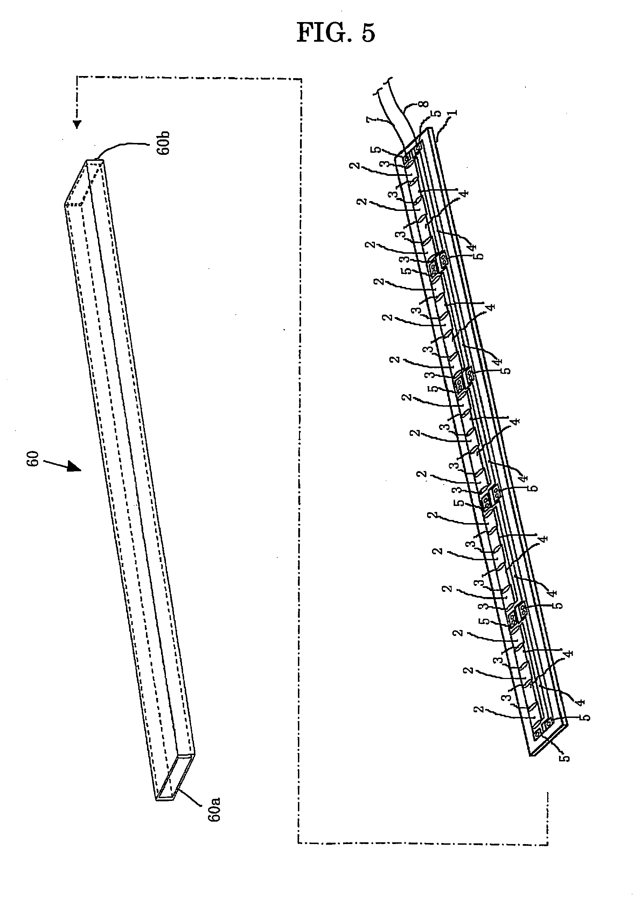

For the abovedescribed embodiment, a description was provided of an example wherein the substrate 1 is molded using the resin 6; however, this embodiment is not provided by way of limitation to the present invention. It is also possible to insert the substrate 1 into a resin shaped like a hollow tube, and seal an opening of the tube-shaped resin, thereby covering the substrate 1 with the resin.
This example is shown in FIG. 5. Descriptions of the structures that are the same as in the abovementioned embodiment and that have the same reference symbols shall be omitted.
In FIG. 5, a plastic tube 60 is formed to be hollow, and a through-hole is formed in an interior thereof. The through-hole is formed slightly wider than a width of the substrate 1. In the example shown in the drawing, the cross-section of the hollow part of the plastic tube 60 is square-shaped (rectangular in the example in the drawing); however, the cross-section may be circular, ovoid, or in any other shape.
Openings 60a, 60b are formed on either end part of the plastic tube 60. The substrate 1 is inserted through one of these openings (60b in the example shown in drawing) into the through-hole of the plastic tube 60, and is covered by the plastic tube. Once the substrate 1 has been inserted into the plastic tube 60 in such a state, the openings 60a, 60b are welded, bonded, or otherwise sealed, whereby the substrate 1 is covered by the plastic tube 60 and a sealed state is obtained.

Resins made of silicone or another substance, which are exceptionally flexible, are used for the plastic tube 60.
The plastic tube 60 does not have to have an opening on both sides. It is possible for the opening (60a) on one end part to be closed in advance to form a pouch-like shape, and the substrate 1 inserted into the opening 60b of the other end part, whereupon the opening 60b is welded or bonded, and thereby sealed.

According to this other embodiment of the present invention, merely inserting the substrate 1 into the plastic tube 60 thus covers the substrate 1 with the resin.
Therefore, the amount of resin used is smaller than in a case where molding is performed, and as long as the hollow tube 60 is prepared beforehand the manufacturing step will be simplified.

### BRIEF DESCRIPTION OF THE DRAWINGS

FIG. 1 is an exploded perspective view of a light-emitting device according to the present embodiment;
FIG. 2 is a side view of the light-emitting device according to the present embodiment;
FIG. 3 is a rear view of the light-emitting device of the present embodiment;
FIG. 4 is a diagram schematically illustrating connected light-emitting elements; and
FIG. 5 is an exploded perspective view of a light-emitting device according to another embodiment.

### [Key]

- 1: Substrate
- 2: Light-emitting element
- 4: Wire
- 5: Electrode clasp
- 6: Molded part
- 60: Plastic tube

## Claims

1. A flexible light-emitting device wherein light-emitting elements are disposed at predetermined intervals on a flexible wired substrate, and the flexible substrate is covered by a soft resin; the light-emitting device
**characterized in that:**
the light-emitting elements are structured into units, each comprising several light-emitting devices as a single set, and
are structured to be capable of being cut between each of the units to achieve a desired length.

2. The flexible light-emitting device according to claim 1, wherein:
the flexible resin is configured in the shape of a hollow tube; and
the flexible substrate is inserted into and sealed within the tube-shaped flexible resin, whereby the flexible substrate is covered.

3. The flexible light-emitting device according to claim 1 or 2, wherein an electrode clasp is disposed between each of the units, and the electrode clasps are structured so as to be capable of being cut.

4. The flexible light-emitting device according to claim 3, wherein a hole for attaching a wiring cord used to establish a connection to an exterior electrode is formed in the electrode clasp.

5. A flexible light-emitting device molded into the form of a sheet using a flexible resin and having light-emitting elements disposed on a flexible wired substrate;
the light-emitting device **characterized in that** the light-emitting elements are disposed in a row at predetermined intervals on one end part of the flexible substrate, and are disposed so as to be imparted with directivity in the thickness direction of the molding resin that is formed in the shape of a sheet.

6. The flexible light-emitting device according to claim 5, wherein the molding resin is constructed from a transparent urethane resin.

7. The flexible light-emitting device according to claim 6 or 7, wherein a set of several light-emitting devices is structured as one unit, electrode clasps are disposed between each of the units, and the electrode clasps are structured so as to be capable of being cut.

8. The flexible light-emitting device according to claim 7, wherein there are formed in the electrode clasps through-holes through which wiring cords for establishing a connection to an exterior electrode are attached.

9. The flexible light-emitting device according to any of claims 6 to 8, wherein the light-emitting elements are "side-view" type light-emitting elements.
